# FASCICULE DE BREVET EUROPEEN

(11) **EP 4 028 275 B1**
(45) Date de publication et mention de la délivrance du brevet: **05.03.2025**
(21) Numéro de dépôt: 20786022.2
(22) Date de dépôt: 07.09.2020
(51) Int. Cl.: B60K 11/08, B60H 1/00, B60H 1/14, B60H 1/32

(54) **PROCÉDÉ DE CONTRÔLE D'UN CIRCUIT DE FLUIDE RÉFRIGERANT POUR VÉHICULE**
VERFAHREN ZUM STEUERN EINES KÜHLMITTELKREISLAUFS FÜR EIN FAHRZEUG
METHOD FOR CONTROLLING A COOLANT CIRCUIT FOR VEHICLE

(30) Priorité: 09.09.2019 FR 1909877
(43) Date de publication de la demande: 20.07.2022
(73) Titulaire: VALEO SYSTEMES THERMIQUES, 78320 Le Mesnil Saint-Denis (FR)
(72) Inventeur: NICOLAS, Bertrand, 78320 LE MESNIL SAINT-DENIS (FR); YAHIA, Mohamed, 78320 LE MESNIL SAINT-DENIS (FR)
(74) Mandataire: Valeo Systèmes Thermiques
(86) Numéro de dépôt international: PCT/FR2020/051543
(87) Numéro de publication internationale: WO 2021/048491

(56) Documents cités:
- DE-A1- 102017 125 170
- DE-A1- 102017 220 376
- US-A1- 2018 086 224
- US-A1- 2019 041 968

## Description

Le domaine de la présente invention est celui des circuits de fluide réfrigérant pour véhicule, notamment pour véhicule automobile. L'invention concerne également un procédé de contrôle d'un tel circuit. Un procédé de contrôle d'un circuit de régulation thermique d'un type connu est divulgué par DE 10 2017 125170 A1.

Les véhicules automobiles sont couramment équipés d'un circuit de fluide réfrigérant utilisé pour chauffer ou refroidir différentes zones ou différents composants du véhicule. Il est notamment connu d'utiliser ce circuit de fluide réfrigérant pour traiter thermiquement un flux d'air envoyé dans l'habitacle du véhicule.

Dans une autre application de ce circuit, il est connu de refroidir un dispositif de stockage électrique utilisé pour fournir une énergie aux éléments d'une chaîne de traction électrique du véhicule, en particulier un moteur électrique, capable de mettre en mouvement ledit véhicule, et un convertisseur électrique associé, destiné à convertir le courant électrique continu délivré par le dispositif de stockage électrique en courant alternatif pour alimenter le moteur électrique. Le circuit de fluide réfrigérant fournit ainsi l'énergie capable de refroidir le dispositif de stockage électrique pendant son utilisation en phases de roulage. Le circuit de fluide réfrigérant est ainsi dimensionné pour refroidir ce dispositif de stockage électrique pour des températures qui restent modérées.

Il est également connu de charger le dispositif de stockage électrique du véhicule en le raccordant pendant plusieurs heures au réseau électrique domestique. Cette technique de charge longue permet de maintenir la température du dispositif de stockage électrique en dessous d'un certain seuil, ce qui permet de se passer de tout système de refroidissement du dispositif de stockage électrique.

Une technique de charge rapide peut également être employée. Elle consiste à charger le dispositif de stockage électrique sous une tension et un ampérage élevés, de manière à charger le dispositif de stockage électrique en un temps court de quelques minutes. Cette charge rapide génère un échauffement du dispositif de stockage électrique qu'il convient de refroidir. Cet échauffement impose le dimensionnement des composants car il s'agit de l'une des situations les plus sévères pour la puissance de refroidissement à fournir. Il s'agit par exemple de pouvoir dissiper plus de 17 kW quand bien même la température de l'air ambiant serait élevée, par exemple de 40°C.

Un autre point de dimensionnement correspondant à des conditions parmi les plus sévères pour la puissance de refroidissement à fournir est le fonctionnement avec une puissance dissipée égale à, ou proche de, la puissance maximale disponible. Il correspond à des conditions dans lesquelles la température de l'air ambiant est élevée, à savoir de 45°C, et la vitesse du flux d'air disponible pour le refroidissement est de 3 m/s. Il est alors demandé que la température d'un liquide de refroidissement utilisé pour refroidir les éléments de la chaîne de traction électrique du véhicule soit inférieure à une température maximale admissible Tmax ( par exemple 70°C ) après refroidissement du convertisseur électrique.

Pour dissiper la chaleur à évacuer, chacun des circuits comprend un échangeur destiné à un échange de chaleur entre un flux d'air externe et, respectivement, le fluide frigorigène et le liquide de refroidissement. Afin d'optimiser l'efficacité thermique, l'idéal serait que chaque échangeur puisse être parcouru par un flux d'air ambiant, c'est-à-dire un flux d'air n'ayant pas déjà traversé un autre échangeur, ceci afin d'éviter que la température du flux d'air traversant l'échangeur situé alors en aval ne soit plus élevé que la température ambiante car échauffé par l'échangeur se trouvant en amont.

Cela étant, dans un véhicule, ces échangeurs, d'ailleurs appelés échangeurs de face avant, sont généralement disposés à l'avant du véhicule, derrière la calandre, et la surface disponible est limitée. Il est alors nécessaire de placer les échangeurs les uns derrière les autres selon le sens de circulation du flux d'air et seul l'un d'eux, situé en amont, pourra bénéficier de l'air ambiant, le flux d'air traversant celui situé en aval étant alors à une température supérieure à la température de l'air ambiant.

Une première option est alors de favoriser le refroidissement du circuit de liquide de refroidissement en plaçant l'échangeur de face avant associé en premier rang, autrement dit en amont selon le sens de circulation du flux d'air. Le refroidissement du fluide frigorigène est alors limité et il est nécessaire de surdimensionner les composants du circuit, en particulier son compresseur, pour disposer de la puissance de refroidissement nécessaire.

Une autre option est de favoriser le refroidissement du circuit de fluide frigorigène en plaçant l'échangeur de face avant associé en premier rang, autrement dit en amont selon le sens de circulation du flux d'air. Cela étant, c'est alors le refroidissement de fluide caloporteur qui est limité.

Une solution alternative, correspondant à une demande de brevet non publiée de la déposante, a été envisagée. Elle consiste à partager le premier rang entre deux échangeurs, à savoir un échangeur associé au circuit de fluide frigorigène et un échangeur associé au circuit de liquide de refroidissement, et attribuer le second rang à échangeur dédié au fluide frigorigène. Bien qu'apportant une amélioration significative, cette solution peut encore être améliorée.

L'invention vise à pallier au moins en partie les problèmes précités et propose à cette fin un procédé de contrôle suivant la revendication 1.

Par « flux d'air ambiant », on entend un flux d'air qui n'a traversé ni le premier échangeur ni le deuxième échangeur avant de traverser le troisième échangeur. Autrement dit, le flux d'air en cause est à température ambiante, c'est à-dire, à la température de l'air à l'extérieur du véhicule, quand il traverse le troisième échangeur, car il n'a pas été réchauffé préalablement par un autre échangeur.

L'invention permet de la sorte de disposer d'une puissance de dissipation thermique élevée en relation avec le circuit de fluide frigorigène, permettant en particulier d'assurer un ou des points de fonctionnement correspondant à des conditions d'utilisation sévères, telle que la charge rapide d'une dispositif de stockage d'énergie, ceci grâce au troisième échangeur de chaleur qui complète la puissance de dissipation du premier échangeur, et de façon d'autant plus efficace que ledit troisième échangeur est destiné à un échange de chaleur avec de l'air ambiant. Parallèlement, les capacités de dissipation thermique du circuit de fluide caloporteur sont préservées grâce au deuxième échangeur qui pourra avoir une surface frontale agrandie par rapport à une situation où il partagerait la surface frontale disponible avec un autre échangeur.

Le circuit contrôlé par le procédé de l'invention pourra également présenter les caractéristiques suivantes, prises seules ou selon toutes combinaisons techniquement possibles qui forment autant de modes de réalisation de l'invention :
- ledit circuit est configuré pour que la circulation du fluide caloporteur permette un refroidissement d'un ou plusieurs éléments d'une chaîne de traction électrique du véhicule,
- ledit circuit est configuré pour que la circulation en série du fluide frigorigène dans les premier et troisième échangeurs permette un refroidissement, dit rapide, d'un dispositif de stockage d'énergie électrique et/ou le traitement thermique d'un habitacle du véhicule,
- lesdits premier et deuxième échangeurs thermiques sont destinés à être positionnés en face avant du véhicule,
- lesdits premier et deuxième échangeurs thermiques présentent une surface frontale sensiblement identique,
- ledit troisième échangeur présente une surface frontale inférieure à celle des premier et/ou deuxième échangeurs,
- ledit troisième échangeur est destiné à être positionné en face avant du véhicule, en amont du premier et du deuxième échangeur selon le sens de circulation du flux d'air les traversant,
- ledit circuit comprend un quatrième échangeur, configuré pour être parcouru par le fluide caloporteur,
- ledit circuit est configuré pour autoriser en outre, sélectivement, une circulation du fluide caloporteur dans le deuxième échangeur et une circulation du fluide caloporteur dans le deuxième et le quatrième échangeur de chaleur,
- la circulation du fluide caloporteur dans le deuxième et le quatrième échangeur de chaleur s'effectue en série,
- le troisième échangeur et le quatrième échangeur sont disposés côte à côte selon le sens de la circulation du flux d'air,
- ledit troisième échangeur et ledit quatrième échangeur, pris ensemble, présentent une surface frontale sensiblement identique à la surface frontale dudit premier et/ou dudit deuxième échangeur de chaleur,
- ledit circuit est configuré pour autoriser sélectivement une circulation du fluide frigorigène dans le premier échangeur ou la circulation en série du fluide frigorigène dans les premier et troisième échangeurs,
- ledit circuit est configuré pour que la circulation du fluide frigorigène dans le premier échangeur de chaleur permette un refroidissement, dit opérationnel, du dispositif de stockage électrique et/ou un traitement thermique d'un habitacle du véhicule,
- ledit circuit comprend un cinquième échangeur, dit bi-fluide, configuré pour permettre un échange de chaleur entre ledit fluide frigorigène et ledit fluide caloporteur,
- ledit circuit comprend un radiateur de chauffage destiné à être parcouru par le fluide caloporteur, ledit circuit étant configuré pour que le fluide caloporteur circulant dans l'échangeur bifluide circule dans ledit radiateur, selon au moins un mode de fonctionnement dudit circuit,
- ledit circuit est configuré pour que, selon au moins un mode de fonctionnement, ledit cinquième échangeur soit situé en amont dudit premier échangeur selon le sens de circulation du fluide frigorigène,
- ledit circuit comprend une bouteille configurée pour une séparation de phase entre une phase vapeur et une phase liquide dudit fluide frigorigène,
- ladite bouteille est intégrée dans ledit premier échangeur,
- ladite bouteille est située entre ledit premier et ledit troisième échangeur, selon le sens de circulation du fluide frigorigène.

Selon l'invention, il a été constaté par le déposant que, compte-tenu des moments différents où la charge rapide de la batterie et les conditions de fonctionnement à puissance maximale interviennent, la dissipation de chaleur pouvait être optimisée selon une autre approche.

Autrement dit, selon l'invention, l'échangeur de chaleur se trouvant en premier rang, à savoir l'échangeur de chaleur supplémentaire, n'est pas parcouru en permanence par le fluide caloporteur. Il ne réchauffe donc pas le flux d'air incident. Il est donc possible de préserver une bonne capacité de dissipation thermique pour le fluide frigorigène quand l'échangeur de chaleur supplémentaire n'est pas parcouru par le fluide caloporteur, par exemple quand le véhicule est à l'arrêt et qu'il faut refroidir le dispositif de stockage électrique du véhicule. A l'inverse, quand l'échangeur de chaleur supplémentaire est parcouru par le fluide caloporteur, la puissance de dissipation offerte par le fluide caloporteur est optimisée et permet d'assurer le refroidissement de la chaine de traction du véhicule, y compris dans les conditions les plus sévères du type fonctionnement à puissance maximale.

Le procédé conforme à l'invention pourra également présenter les caractéristiques suivantes, prises seules ou selon toutes combinaisons techniquement possibles qui forment autant de modes de réalisation de l'invention :
- ledit circuit est configuré de sorte à ce que le flux d'air qui traverse ledit échangeur de chaleur supplémentaire soit un flux d'air ambiant,
- ledit procédé comprend une étape de contrôle d'au moins un paramètre relatif au fluide caloporteur,
- ledit paramètre est la température du fluide caloporteur,
- l'étape dans laquelle on génère ou on augmente le débit de fluide caloporteur dans l'échangeur supplémentaire est réalisée en fonction d'une valeur dudit paramètre,
- l'étape dans laquelle on génère ou on augmente le débit de fluide caloporteur dans l'échangeur supplémentaire s'effectue par comparaison de la valeur du paramètre par rapport à une valeur seuil,
- ledit circuit est configuré pour que la circulation du fluide caloporteur permette un refroidissement d'un ou plusieurs éléments d'une chaîne de traction électrique du véhicule,
- ledit circuit est configuré pour que la circulation du fluide caloporteur permette un refroidissement d'un convertisseur électrique, destiné à convertir un courant électrique continu délivré par un dispositif de stockage électrique en courant alternatif pour alimenter un moteur électrique capable de mettre en mouvement ledit véhicule,
- l'étape dans laquelle on génère ou on augmente le débit de fluide caloporteur dans l'échangeur supplémentaire intervient si la température du fluide caloporteur est légèrement inférieure, égale ou supérieure à la température maximale admissibleTmax,
- ledit procédé comprend une étape dans laquelle on autorise, sélectivement, une circulation du fluide caloporteur dans le deuxième échangeur et une circulation du fluide caloporteur dans le deuxième échangeur et dans l'échangeur de chaleur supplémentaire,
- ladite étape dans laquelle on génère ou on augmente le débit de fluide caloporteur dans l'échangeur supplémentaire comprend une étape d'ouverture/fermeture de ladite vanne, en tout ou rien et/ou de façon partielle,
- ladite vanne est formée par un thermostat et/ou une vanne à pilotage électronique,
- la circulation du fluide caloporteur dans le deuxième échangeur de chaleur et l'échangeur de chaleur supplémentaire s'effectue en série,
- lesdits premier et deuxième échangeurs thermiques présentent une surface frontale sensiblement identique,
- ledit échangeur supplémentaire présente une surface frontale inférieure ou égale à celle des premier et/ou deuxième échangeurs,
- lesdits premier et deuxième échangeurs thermiques ainsi que ledit échangeur supplémentaire sont destinés à être positionnés en face avant du véhicule,
- au-dessus d'une vitesse seuil du véhicule, on prévoit une situation initiale dans laquelle les volets sont clos de sorte que la section de passage du flux d'air est nulle ou minimum
- au-dessus de la vitesse seuil du véhicule, on réalise d'abord la sous-étape (c) puis la sous-étape (b) si cela reste insuffisant par rapport à une consigne à atteindre
- à l'arrêt et/ou à une vitesse du véhicule inférieur à la vitesse seuil, on réalise d'abord la sous-étape (a) puis, si cela reste insuffisant par rapport à une consigne à atteindre, on réalise la sous-étape (c),
- à l'arrêt et/ou à une vitesse du véhicule inférieur à la vitesse seuil, on réalise la sous-étape (b) si la consigne n'est pas atteinte à l'issue de la sous-étape (a) puis on réalise la sous-étape (c) si la consigne n'est pas atteinte à l'issue de la sous-étape (b),
- on déleste un fonctionnement d'une boucle de circulation du fluide frigorigène si la consigne n'est pas atteinte malgré la mise en œuvre des sous-étapes (a), (b) et (c),
- on adapte ladite vitesse seuil du véhicule en fonction de la température ambiante,
- ledit circuit comprend un échangeur, dit bi-fluide, configuré pour permettre un échange de chaleur entre ledit fluide frigorigène et ledit fluide caloporteur,
- ledit circuit comprend un radiateur de chauffage destiné à être parcouru par le fluide caloporteur, ledit circuit étant configuré pour que le fluide caloporteur circulant dans l'échangeur bifluide circule dans ledit radiateur, selon au moins un mode de fonctionnement dudit circuit,
- ledit circuit est configuré pour que, selon au moins un mode de fonctionnement, l'échangeur bifluide soit situé en amont dudit premier échangeur selon le sens de circulation du fluide frigorigène,
- ledit circuit comprend une bouteille configurée pour une séparation de phase entre une phase vapeur et une phase liquide dudit fluide frigorigène,
- ladite bouteille est intégrée dans ledit premier échangeur.

D'autres caractéristiques et avantages de l'invention apparaitront au cours de la lecture de la description détaillée qui va suivre pour la compréhension de laquelle on se reportera aux dessins annexés dans lesquels :
La figure 1 illustre de façon schématique un exemple de réalisation d'un premier circuit conforme à l'invention comprenant une boucle de circulation d'un fluide frigorigène et une boucle de circulation d'un fluide caloporteur,
La figure 2 illustre de façon schématique la circulation des différents fluides selon un premier mode de fonctionnement du circuit de la figure 1
La figure 3 illustre de façon schématique la circulation des différents fluides selon un deuxième mode de fonctionnement du circuit de la figure 1
La figure 4 illustre de façon schématique la circulation des différents fluides selon une troisième mode de fonctionnement du circuit de la figure 1
La figure 5 est un logigramme illustrant un exemple de réalisation d'un procédé de contrôle conforme à l'invention.

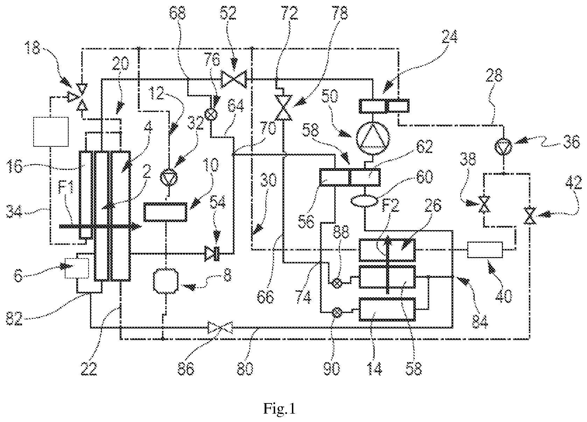

Comme illustré aux figures 1 à 4, l'invention concerne un procédé de contrôle d'un circuit de régulation thermique pour véhicule, notamment véhicule automobile. Il comprend ici une boucle, en particulier une boucle fermée, de circulation d'un fluide frigorigène et une boucle, en particulier une boucle fermée, de fluide caloporteur.

Les termes amont et aval employés dans la description qui suit se réfèrent au sens de circulation du fluide considéré, c'est-à-dire le fluide réfrigérant, le fluide caloporteur, un flux d'air extérieur à un habitacle du véhicule et/ou un flux d'air intérieur envoyé vers l'habitacle du véhicule.

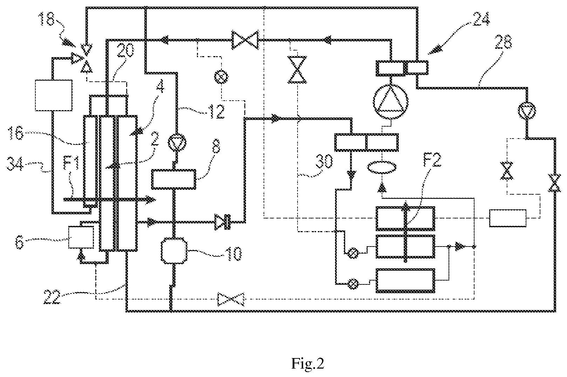

A la figure 1, la boucle de fluide frigorigène est illustrée en traits pleins et la boucle de fluide caloporteur est illustrée en traits mixtes. Aux figures 2 à 4, pour chacune des boucles, les portions parcourues par leur fluide respectif sont en traits pleins et les portions sans circulation de fluide en traits pointillés. Par ailleurs, la circulation du fluide frigorigène est illustrée en indiquant son sens de circulation par des flèches. Des traits pleins d'épaisseur différente sont de plus utilisés. Plus précisément, les traits les plus épais correspondent à des portions haute pression, le trait d'épaisseur intermédiaire à des portions intermédiaire et les traits les plus fins à des portions basse pression de la boucle de fluide frigorigène.

Les dénominations « premier/ère », « deuxième », etc...utilisées dans la suite n'ont pas vocation à indiquer un niveau de hiérarchisation ou ordonnancer les termes qu'elles accompagnent. Ces dénominations permettent de distinguer les termes qu'elles accompagnent et peuvent être interverties sans que soit réduite la portée de l'invention.

Le fluide frigorigène est par exemple un fluide susceptible de passer de phase liquide à gazeuse et réciproquement dans les conditions de température et de pression du circuit. Il peut s'agir d'un fluide connu sous le nom de R134a ou d'un fluide connu sous le nom de R1234yf. Il pourra encore s'agir d'un fluide restant essentiellement à l'état gazeux comme le R744.

Le fluide caloporteur est par exemple un liquide, notamment de l'eau additionnée d'antigel tel que du glycol.

Ledit circuit comprend des premier 2, deuxième 4 et troisième 6 échangeurs de chaleur. Ledit circuit est configuré pour autoriser une circulation en série du fluide frigorigène dans les premier 2 et le troisième 6 échangeurs et une circulation du fluide caloporteur dans le deuxième échangeur 4. Autrement dit, ici, le premier et le troisième échangeur sont dans la boucle de circulation du fluide frigorigène et le deuxième échangeur 4 est dans la boucle de fluide caloporteur.

En outre, les premier 2 et le troisième 6 échangeurs sont situés en série selon un sens de circulation d'un flux d'air, illustré par une flèche repérée F1, destiné à les traverser dans cet ordre. De son côté, le troisième échangeur de chaleur 6 est destiné à être traversé par un flux d'air ambiant, autrement dit de l'air non encore réchauffé par le premier 2 et/ou le deuxième 4 échangeurs. Comme cela sera détaillé plus tard, dans le mode de réalisation illustré, il s'agit du même flux d'air F1 que celui traversant les premier et deuxième échangeurs 2, 4 le flux d'air F1 traversant alors, dans cet ordre, le troisième échangeur 6, le premier échangeur 2 et le deuxième échangeur 4.

Par la mise en série du premier 2 et du troisième 6 échangeurs de chaleur vis-à-vis du fluide réfrigérant, on dispose d'une puissance de dissipation de chaleur élevée, ceci d'autant plus que le troisième échangeur 6 est traversé par de l'air frais refroidissant donc d'autant plus efficacement le fluide frigorigène. Ce dernier pourra ainsi être utilisé pour refroidir différents composants ou zones du véhicule, y compris dans les conditions d'utilisation du circuit les plus sévères. Par ailleurs, le deuxième échangeur 4 pourra être utilisé pour refroidir d'autres composants à l'aide du fluide caloporteur, ceci avec la possibilité de présenter une large surface frontale car se trouvant en aval du premier échangeur 2 selon le sens de circulation du flux d'air. Cette surface frontale n'interfère donc pas avec celle du troisième échangeur 6 qui se trouve soit en amont du premier échangeur 2 selon le sens de circulation du flux d'air soit ailleurs dans le véhicule pour autant qu'il puisse être traversé par un flux d'air ambiant.

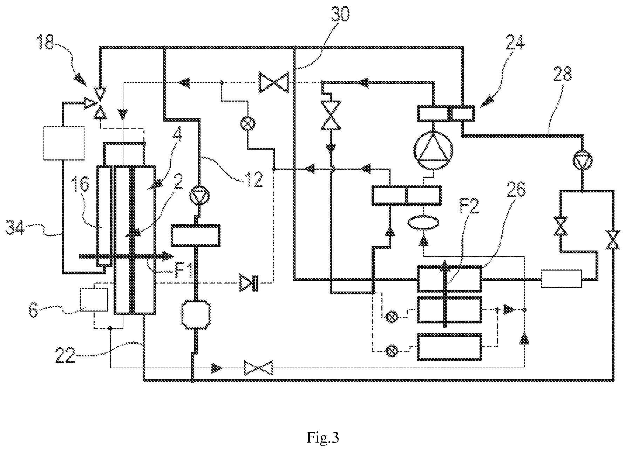

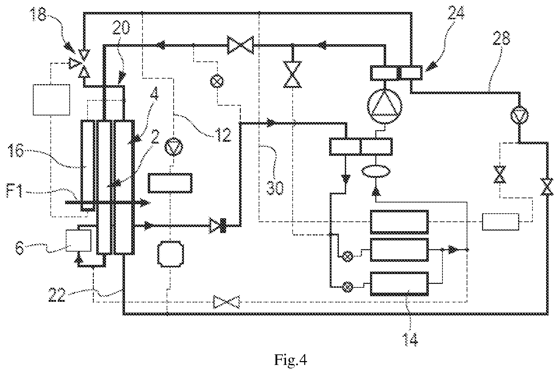

Comme cela sera développé plus loin, le circuit peut être configuré pour que le passage en série du fluide frigorigène dans le premier 2 et le troisième 6 échangeurs n'interviennent pas systématiquement mais seulement dans certains modes de fonctionnement. Cela est le cas dans l'exemple illustré où la circulation en série intervient dans les modes de fonctionnement des figures 2 et 4 mais pas dans le mode de fonctionnement de la figure 3.

Le premier échangeur 2 est formé, par exemple, d'un condenseur ou refroidisseur de gaz. Le troisième échangeur 6 est configuré, par exemple, pour effectuer un sous refroidissement dudit fluide frigorigène après son passage dans le condenseur ou refroidisseur de gaz. Il s'agit, par exemple, d'échangeurs comprenant un faisceau d'échange de chaleur à tubes et intercalaires. Les tubes sont destinés à la circulation du fluide frigorigène. Les intercalaires sont en contact avec les tubes et sont destinés à être traversé par le flux d'air. Ledit condenseur présente une ou plusieurs passes de circulation du fluide frigorigène.

Ledit circuit est ici configuré pour que la circulation du fluide caloporteur permette, par exemple, un refroidissement d'un ou plusieurs éléments d'une chaîne de traction électrique du véhicule tel qu'un moteur électrique 8, capable de mettre en mouvement ledit véhicule, et un convertisseur électrique 10 associé, destiné à convertir le courant électrique continu délivré par un dispositif de stockage électrique en courant alternatif pour alimenter le moteur électrique 8. Pour cela, la boucle de circulation du fluide caloporteur comprend avantageusement une première branche 12 traversant dans cet ordre selon le sens de circulation du fluide caloporteur le convertisseur électrique 10 et le moteur électrique 8. En variante, le convertisseur 10 et/ou le moteur 8 ne sont pas directement parcourus par le fluide caloporteur mais par un fluide annexe, ledit fluide annexe échangeant de la chaleur avec le fluide caloporteur à l'aide d'un échangeur de chaleur relié au composant en cause par une boucle spécifique de circulation du fluide annexe.

Dans le mode de réalisation illustré, un tel refroidissement a lieu dans le mode de fonctionnement illustré figure 2.

Ledit circuit est en outre ici configuré pour que la circulation en série du fluide frigorigène dans la premier 2 et le troisième 6 échangeurs permette un refroidissement, dit rapide, du dispositif de stockage d'énergie électrique et/ou le traitement thermique d'un habitacle du véhicule. Le dispositif de stockage d'énergie électrique n'est pas représenté en tant que tel. Il pourra être directement au contact d'un élément de la boucle de circulation de fluide frigorigène tel qu'un refroidisseur 14. En variante, il pourra être refroidi par un fluide annexe échangeant lui-même de la chaleur avec le fluide frigorigène, par exemple à l'aide dudit refroidisseur 14. Dans le mode de réalisation illustré, le mode de fonctionnement associé, dit de refroidissement rapide du dispositif de stockage d'énergie électrique, est rencontré figure 4.

Préférentiellement, lesdits premier et deuxième échangeurs thermiques 2, 4 sont destinés à être positionnés en face avant du véhicule, par exemple derrière sa calandre. Ils présentent avantageusement une surface frontale sensiblement identique, en particulier de manière à occuper chacun la plus grande surface disponible. Par surface frontale, on entend la surface de l'échangeur dans un plan perpendiculaire au flux d'air F1, c'est-à-dire, dans un plan sensiblement parallèle à la calandre.

Avantageusement, comme déjà évoqué, ledit troisième échangeur 6 est aussi destiné à être positionné en face avant du véhicule et traversé par le flux d'air F1. Il est alors situé en amont des premier 2 et du deuxième 4 échangeurs selon le sens de circulation du flux d'air.

Dans un tel emplacement, ledit troisième échangeur 6 présente une surface frontale inférieure à celle des premier et/ou deuxième échangeurs 2, 4. Cela étant, cette caractéristique pourra aussi s'appliquer lorsque le troisième échangeur 6 se trouve en un autre emplacement. A ce sujet, ledit troisième échangeur 6 pourra être localisé, par exemple, dans un passage de roue. Sa surface frontale est alors adaptée à la place disponible.

Avantageusement, ledit circuit comprend un quatrième échangeur 16 qui est ici disposé à côté du troisième échangeur 6 de sorte que les troisième 6 et le quatrième 16 échangeurs sont traversés parallèlement par ledit flux d'air F1. Préférentiellement, ledit troisième échangeur 6 et ledit quatrième échangeur 16, pris ensemble, présentent une surface frontale sensiblement identique à la surface frontale desdits premier 2 et deuxième 4 échangeurs de chaleur.

Le deuxième échangeur 4 est formé, par exemple, d'un radiateur de refroidissement. Il pourra être qualifié de radiateur à température basse. Le quatrième échangeur 16 est configuré, par exemple, pour effectuer un refroidissement complémentaire dudit fluide caloporteur. Il pourra être qualifié d'échangeur à température très basse. Il s'agit, par exemple, d'échangeurs comprenant un faisceau d'échange de chaleur à tubes et intercalaires. Les tubes sont destinés à la circulation du fluide de refroidissement. Les intercalaires sont en contact avec les tubes et sont destinés à être traversé par le flux d'air.

Ledit circuit est configuré pour autoriser en outre, sélectivement, une circulation du fluide caloporteur dans le deuxième échangeur 4, sans passage dans la quatrième échangeur 16, comme cela est le cas à la figure 4, et une circulation du fluide caloporteur dans les deuxième 4 et quatrième 16 échangeurs de chaleur, comme cela est le cas aux figures 2 et 3. Autrement dit, ici, ledit quatrième échangeur 16 est intégré dans la boucle de circulation du fluide caloporteur. Lorsqu'aucune circulation de fluide caloporteur n'a lieu dans le quatrième échangeur 16, cela favorise l'efficacité du premier échangeur 2 car le flux d'air traversant ce dernier est alors un flux d'air à température ambiante, au moins sur la portion dudit premier échangeur 2 se trouvant en vis-à-vis du quatrième échangeur 16. Lorsque la circulation du fluide caloporteur a lieu à la fois dans les deuxième 4 et quatrième 16 échangeurs, cela favorise la capacité de dissipation de chaleur en face avant offerte par la boucle de circulation du fluide caloporteur, ceci d'autant plus quand le quatrième échangeur 16 est traversé par un flux d'air ambiant, comme dans le mode de réalisation illustré.

La circulation du fluide caloporteur dans les deuxième 4 et quatrième 16 échangeurs de chaleur s'effectue ici en série. En variante, elle s'effectue en parallèle.

Ledit circuit comprend en outre au moins une vanne 18 permettant, selon le sens de circulation dudit fluide caloporteur, de diriger sélectivement le fluide caloporteur en aval du deuxième échangeur 4 vers ledit quatrième échangeur 16, comme aux figures 2 et 3, ou directement vers le reste du circuit, comme à la figure 4. Il s'agit, par exemple d'une vanne trois voies avec ici une première entrée, une deuxième entrée et une sortie commune.

Ladite première entrée est reliée, par exemple, à une portion 20 d'une seconde branche 22 de la boucle de circulation du fluide de refroidissement comprenant ledit deuxième échangeur 4, ladite portion 20 permettant de contourner ledit quatrième échangeur 16 en sortie du deuxième échangeur 4. Ladite seconde entrée en reliée au quatrième échangeur de chaleur 16. Ladite sortie commune est reliée en particulier à la première branche 12 de ladite boucle de circulation du fluide de refroidissement.

En variante, ladite vanne 18 comprend une entrée commune, une première sortie et une deuxième sortie. L'entrée est alors reliée au deuxième échangeur 4, la première sortie à la portion 20 de la seconde branche 22 de la boucle de circulation du fluide de refroidissement et la seconde sortie au quatrième échangeur de chaleur 16.

Ladite vanne 18 est formée, notamment, par un thermostat et/ou une vanne à pilotage électronique permettant de mettre sélectivement en relation la première et/ou la secondé entrée de ladite vanne avec la sortie commune et/ou l'entrée commune avec la première et/ou la seconde sortie.

Comme évoqué plus haut, préférentiellement, ledit circuit est configuré pour autoriser sélectivement une circulation du fluide frigorigène dans le premier échangeur 2, sans passage dans le troisième échangeur 6, comme à la figure 3, ou la circulation en série du fluide frigorigène dans les premier 2 et troisième 6 échangeurs, comme aux figures 2 et 4. Il est de la sorte possible de ne pas systématiquement utiliser le troisième échangeur 6, ce qui peut être avantageux pour limiter les pertes de charges dans la boucle de fluide frigorigène quand les besoins de dissipation thermique sont limités.

Un tel mode de fonctionnement est par exemple employé pour un refroidissement, dit opérationnel, du dispositif de stockage électrique c'est-à-dire un refroidissement nécessitant une dissipation de chaleur moins importante qu'en cas de recharge rapide, et/ou pour un traitement thermique de l'habitacle du véhicule. Cela est par exemple le cas pour un fonctionnement en mode pompe à chaleur, comme à la figure 3. Dans un tel mode de réalisation, selon le mode de réalisation illustré, des calories sont prélevés sur le flux d'air F1 traversant le premier échangeur 2 et restitué, tel que cela sera développé plus bas à un flux d'air, illustré F2, destiné à pénétrer dans l'habitacle du véhicule pour le réchauffer. Ledit circuit est ainsi configuré pour que la circulation du fluide frigorigène dans le premier échangeur de chaleur 2, sans passage dans le troisième échangeur 6, permette un tel résultat.

Préférentiellement, ledit circuit comprend un cinquième échangeur 24, dit bi-fluide, configuré pour permettre un échange de chaleur entre ledit fluide frigorigène et ledit fluide caloporteur. Un tel échangeur se trouve donc à la fois dans la boucle de fluide frigorigène et la boucle de fluide de refroidissement. Il s'agit, par exemple, d'un condenseur, notamment d'un condenseur à plaques empilées.

Préférentiellement, ledit circuit, en particulier ladite boucle de circulation du fluide caloporteur, comprend un radiateur de chauffage 26 destiné à être parcouru par le fluide caloporteur. Ledit circuit est configuré pour que le fluide caloporteur circulant dans l'échangeur bifluide 24 circule dans ledit radiateur de chauffage 26, selon au moins un mode de fonctionnement dudit circuit, notamment le mode pompe à chaleur évoqué plus haut.

Dans ce mode, comme illustré à la figure 3, les calories sont prélevées sur le flux d'air F1 traversant le premier échangeur 2 et transmise par ledit échangeur 2 au fluide frigorigène. Elles sont alors transmises au fluide de refroidissement par ledit cinquième échangeur 24 et au flux d'air F2 destiné à pénétrer dans l'habitacle du véhicule par le radiateur de chauffage 26.

Préférentiellement, ledit circuit est configuré pour que, selon au moins un mode de fonctionnement, ledit cinquième échangeur 24 soit situé en amont dudit premier échangeur 2 selon le sens de circulation du fluide frigorigène. Les modes de fonctionnement en cause sont, par exemple, un mode de climatisation, rencontré figure 2 selon le mode de réalisation illustré, et/ou le mode de refroidissement rapide du dispositif de stockage d'énergie électrique (pour rappel illustré figure 4). Ainsi, dans les modes en cause, le fluide frigorigène subit à la fois un pré-refroidissement dans le cinquième échangeur 24, un refroidissement, éventuellement avec changement de phase, dans le premier échangeur 2 et si nécessaire un sous-refroidissement dans le troisième échangeur 6. La variation d'enthalpie du fluide frigorigène est alors optimisée ce qui permet de limiter la puissance à fournir à la boucle de fluide frigorigène, à performance équivalente.

Ledit circuit pourra comprendre une bouteille, non illustrée, configurée pour une séparation de phase entre une phase vapeur et une phase liquide dudit fluide frigorigène. Ladite bouteille est par exemple intégrée dans ledit premier échangeur 2 qui pourra alors comprendre ou non, au sein de son faisceau une ou plusieurs passes de sous-refroidissement. Ce sous-refroidissement s'ajoute à celui fourni par le troisième échangeur 6, dans les modes de fonctionnement dans lequel une circulation en série dans les premier 2 et troisième 6 échangeurs intervient. En variante, ladite bouteille est située entre lesdits premier 2 et troisième 6 échangeurs, selon le sens de circulation du fluide frigorigène. Ladite bouteille est avantageusement munie d'un filtre et/ou d'un dessicant.

Selon le mode de réalisation illustré, la boucle de circulation du fluide de refroidissement comprend la première 8 et la deuxième branche 22 déjà évoquées ainsi qu'une troisième branche 28 et une quatrième branche 30, l'ensemble desdites branches 12, 22, 28, 30 étant situées parallèlement entre elles.

La première branche 12 comprend le convertisseur électrique 10 et le moteur électrique 8. Elle comprend une outre une première pompe 32 de mise en circulation du fluide de refroidissement.

La seconde branche 22 comprend le second échangeur 4 et la vanne trois voies 18. En parallèle de sa portion 20, elle comprend en outre une sous-branche 34 munie dudit quatrième échangeur 16.

La troisième branche 28 comprend l'échangeur bi-fluide 26 et une deuxième pompe 36 de mise en circulation du fluide caloporteur.

La quatrième branche 30 comprend un première vanne deux voies 38 et le radiateur de chauffage 26. Elle comprend en outre ici dispositif de chauffage électrique 40 du fluide de refroidissement, destiné à être utilisé en combinaison avec le radiateur de chauffage 26, au besoin.

Ladite boucle de circulation du fluide de refroidissement pourra encore comprendre une deuxième vanne deux voies 42, située entre, d'une part les première 12 et deuxième 22 branches et, d'autre part, les troisième 28 et quatrième 30 branches du côté aval par rapport à la deuxième pompe 36.

Ledit circuit, en particulier ladite boucle de circulation du fluide frigorigène, comprend un dispositif de compression 50 permettant de faire circuler le fluide frigorigène. On notera que le dispositif de compression 50 peut prendre la forme d'un compresseur électrique, c'est-à-dire un compresseur qui comprend un mécanisme de compression, un moteur électrique et éventuellement un contrôleur.

En aval dudit dispositif de compression 50, ladite boucle de circulation du fluide frigorigène comprend ledit échangeur bifluide 24, une troisième vanne deux voies 52, ledit premier échangeur 2, ledit troisième échangeur 6, une vanne anti-retour 54, une première passe 56 d'un échangeur interne 58, et en parallèle l'un avec l'autre dans des branches respectives, un évaporateur 58 et le refroidisseur 14, puis un accumulateur 60 et une deuxième passe 62 de l'échangeur interne 58. Ces composants se suivent dans cet ordre selon une sous-boucle dans laquelle le fluide frigorigène retourne au dispositif de compression 50 après avoir traversé la deuxième passe 62 de l'échangeur interne 58.

Ledit circuit comprend en outre des première 64, deuxième 66 et troisième 80 branches de déviation permettant de modifier le parcours du fluide frigorigène.

La première branche de déviation 64 est située entre un premier point de divergence 68 et un premier point de convergence 70. Le premier point de divergence 68 est situé entre la troisième vanne deux voies 52 et le premier échangeur 2. Le premier point de convergence 70 est situé entre la vanne anti-retour 54 et la première passe 56 de l'échangeur interne 58. Ladite première branche de déviation 64 comprend un premier organe de détente 76. Ledit organe de détente est configuré pour sélectivement ouvrir totalement ladite première branche de déviation 64, fermer totalement ladite première branche de déviation 64 ou opérer une détente du fluide frigorigène circulant dans ladite première branche de déviation 64.

La deuxième branche de déviation 66 est située entre un deuxième point de divergence 72 et un deuxième point de convergence 74. Le deuxième point de divergence 72 est situé entre l'échangeur bifluide 24 et la troisième vanne deux voies 52. Le deuxième point de convergence 74 est situé entre la première passe 56 de l'échangeur interne 58 et une portion, ici un point, de la sous-boucle évoquée plus haut et permettant l'alimentation en parallèle de l'évaporateur 58 et du refroidisseur 14. Ladite deuxième branche de déviation 66 comprend une quatrième vanne deux voies 78.

La troisième branche de déviation 80 est située entre un troisième point de divergence 82 et un troisième point de convergence 84. Le troisième point de divergence 82 est situé entre le premier échangeur 2 et le troisième échangeur 6. Le troisième point de convergence 84 est situé entre, d'une part, une portion, ici un point, de la sous-boucle évoquée plus haut et permettant de collecter en parallèle le fluide frigorigène sortant de l'évaporateur 58 et du refroidisseur 14 et, d'autre part, l'accumulateur 60. Ladite troisième branche de déviation 80 comprend une cinquième vanne deux voies 86.

La boucle de circulation du fluide frigorigène comprend encore des deuxième 88 et troisième 90 organes de détente respectivement situés en amont de l'évaporateur 58 et du refroidisseur 14 dans les branches associées. Lesdits organes de détente sont configurés pour sélectivement ouvrir totalement lesdites branches, fermer totalement lesdites branches ou opérer une détente du fluide frigorigène circulant dans lesdites branches.

Selon le mode de fonctionnement illustré à la figure 2, le circuit assure à la fois un mode climatisation et un mode dans lequel la chaleur dégagée par le ou les éléments 8, 10 de la chaîne de traction électrique du véhicule est dissipée de sorte à refroidir le fluide de refroidissement en dessous de la température maximale admissible Tmax en aval du convertisseur 10, y compris dans des conditions d'utilisation du type fonctionnement à puissance maximale.

Dans ce mode de fonctionnement, le fluide de refroidissement circule dans la première branche 12, la deuxième branche 22, en passant par la sous-branche 34, et dans la troisième branche 28 mais pas dans la quatrième branche 30. La vanne trois voies 18 est ouverte de sorte à faire circuler le fluide de refroidissement dans le quatrième échangeur 16, comme expliqué plus haut. La première vanne deux voies 38 est fermée. La deuxième vanne deux voies 42 est ouverte. Les première et/ou deuxième pompes 32, 36 sont actives. De la sorte, le fluide de refroidissement circule boucle dans les première et deuxième branches 12, 22 de sorte que la chaleur dégagée par les éléments de la chaine de traction 8, 10 est dissipée dans l'air par les second et quatrième échangeurs 4, 16. Si les besoins en refroidissement restent limités, le fluide de refroidissement pourra passer par la portion de contournement 20 plutôt que par la sous-branche 34. Le fluide de refroidissement circule également dans la troisième branche 28, en parallèle de la première branche 12, pour permettre le refroidissement du fluide frigorigène au niveau de l'échangeur bifluide 24.

Toujours dans ce mode de fonctionnement, le fluide frigorigène suit la sous-boucle évoqué plus haut. La quatrième vanne deux voies 52 est ouverte et lesdits deuxième 88 et troisième 90 organes de détente fonctionne en détendeur. Le premier organe de détente 76 est fermé ainsi que la quatrième vanne deux voies 78 et la cinquième vanne deux voies 86. La dissipation de chaleur assurée par l'échangeur bi-fluide 24 dans le fluide de refroidissement et par les premier 2 et troisième 6 échangeurs dans le flux d'air F1 permet d'une part de refroidir le dispositif de stockage d'énergie électrique, grâce au refroidisseur 14 et d'autre part de climatiser l'habitacle du véhicule par l'intermédiaire de l'évaporateur 58 qui refroidit le flux d'air F2, notamment lors de phases de roulage du véhicule.

Selon le mode de fonctionnement illustré à la figure 3, comme déjà évoqué, le circuit assure un mode de pompe à chaleur, ici sans refroidissement du dispositif de stockage électrique bien qu'un mode pompe à chaleur reste compatible avec un refroidissement opérationnel dudit dispositif de stockage avec le circuit illustré.

Dans ce mode de fonctionnement, le fluide de refroidissement circule dans la première branche 12, la deuxième branche 22, en passant par la sous-branche 34, dans la troisième branche 28 et dans la quatrième branche 30. La vanne trois voies 18 est ouverte de sorte à faire circuler le fluide de refroidissement dans le quatrième échangeur 16, comme expliqué plus haut. La première vanne deux voies 38 et la deuxième vanne deux voies 42 sont ouvertes. Les première et/ou deuxième pompes 32, 36 sont actives. De la sorte, le fluide de refroidissement circule en boucle dans les troisième et quatrième branches 28, 30 de sorte que la chaleur transmise par l'échangeur bifluide 24 est dissipée dans le flux d'air F2 par le radiateur de chauffage 26 pour un réchauffage de l'habitacle du véhicule. La circulation dans la première branche 12 a lieu en parallèle de la circulation dans la troisième branche 28 de sorte à effectuer une récupération de la chaleur dégagée par les éléments de la chaîne de traction électrique 8, 10. En variante, la circulation du fluide de refroidissement dans la deuxième branche 22 pourra être coupée, ici à l'aide de ladite vanne trois voies 18.

Toujours dans ce mode de fonctionnement, le fluide frigorigène suit un chemin différent de celui de la sous-boucle évoquée plus haut. La troisième vanne deux voies 52 est fermée ainsi que lesdits deuxième 88 et troisième 90 organes de détente. Le premier organe de détente 76 fonctionne en détendeur. La quatrième vanne deux voies 78 et la cinquième vanne deux voies 86 sont ouvertes. En aval du dispositif de compression 50, le fluide frigorigène traverse de la sorte successivement ledit échangeur bifluide 24, la cinquième vanne deux voies 52, la première passe 56 de l'échangeur interne 58, le premier organe de détente 76, ledit premier échangeur 2, ladite sixième vanne 86 puis l'accumulateur 60 et une deuxième passe 62 de l'échangeur interne 58. Le premier échangeur 2 fonctionne alors en évaporateur et capte de la chaleur sur le flux d'air F1 qui sera transmise au flux d'air F2 par l'échangeur bifluide 24 et le radiateur de chauffage 26.

Selon le mode de fonctionnement illustré à la figure 4, comme déjà évoqué, le circuit assure un refroidissement rapide du dispositif de stockage d'énergie. Un tel fonctionnement a généralement lieu quand le véhicule est à l'arrêt et les autres besoins de refroidissement ou les besoins de chauffage sont généralement faibles.

Dans ce mode de fonctionnement, le fluide de refroidissement circule dans la deuxième branche 22, en passant par la portion 20, et dans la troisième branche 28 mais ne circule pas ni dans la première branche 12 ni la quatrième branche 30. La vanne trois voies 18 est ouverte de sorte à faire circuler le fluide de refroidissement dans la portion 20, comme expliqué plus haut. La première vanne deux voies 38 est fermée. La deuxième vanne deux voies 42 est ouverte. La première pompe 32 est inactive tandis que la deuxième pompe 36 est active. De la sorte, le fluide de refroidissement circule en boucle dans la deuxième branche 12 et la troisième branche 28 de sorte à assurer un débit minimum de fluide de refroidissement dans l'échangeur bifluide 24 afin que ledit fluide de refroidissement n'entre pas en ébullition sous l'effet de la chaleur dissipé par le fluide frigorigène.

Toujours dans ce mode de fonctionnement, le fluide frigorigène suit le même chemin que dans le cas de la figure 2, à savoir la sous-boucle évoqué plus haut. La dissipation de chaleur assurée par l'échangeur bi-fluide 24 dans le fluide de refroidissement et par les premier 2 et troisième 6 échangeurs dans le flux d'air F1 permet d'assurer le refroidissement rapide du dispositif de stockage d'énergie par le refroidisseur 14.

L'invention concerne un procédé de contrôle d'un circuit de régulation thermique d'un véhicule. Il pourra s'agir du circuit décrit plus pour autant qu'il comprenne ledit quatrième échangeur 16 alors qualifié d'échangeur supplémentaire selon cet aspect de l'invention. Cela étant, plus largement, ledit procédé pourra également s'appliquer à des configurations sans le troisième échangeur 6, le reste du circuit restant alors avantageusement identique.

En cas d'absence dudit troisième échangeur 6, ledit échangeur de chaleur supplémentaire 16 présente préférentiellement une surface frontale sensiblement identique à celle des premier et/ou second échangeurs de chaleur 2, 4.

Selon cet autre aspect de l'invention, ledit procédé comprend une étape dans laquelle on génère ou on augmente un débit du fluide caloporteur dans l'échangeur supplémentaire 16, en fonction de modes de fonctionnement du circuit. De la sorte, que l'on dispose ou non d'un troisième échangeur 6, on favorise la dissipation de chaleur par le fluide de refroidissement en combinant, quand nécessaire, le deuxième échangeur 4 et l'échangeur supplémentaire 16, comme cela est le cas, par exemple, dans le mode de fonctionnement de la figure 2 selon ce qui a déjà été vu, et ceci de façon d'autant plus efficace que ledit échangeur de chaleur supplémentaire 16 est traversé par un flux d'air ambiant.

Plus précisément, ledit procédé comprend une étape dans laquelle on autorise, sélectivement, une circulation du fluide caloporteur dans le deuxième échangeur 4, sans passage dans l'échangeur supplémentaire 16, et une circulation du fluide caloporteur dans le deuxième échangeur 4 et dans l'échangeur de chaleur supplémentaire 16. On module de la sorte la puissance de dissipation de chaleur en fonction des besoins.

De façon préférentielle, ledit procédé comprend une étape de contrôle d'au moins un paramètre relatif au fluide caloporteur Il s'agit en particulier de la température du fluide caloporteur.

L'étape dans laquelle on génère ou on augmente le débit de fluide caloporteur dans l'échangeur supplémentaire 16 est réalisée en fonction d'une valeur dudit paramètre, notamment par comparaison de la valeur du paramètre par rapport à une valeur seuil.

A titre d'exemple, l'étape dans laquelle on génère ou on augmente le débit de fluide caloporteur dans l'échangeur supplémentaire intervient si la température du fluide caloporteur est légèrement inférieure, égale ou supérieure à la température maximale admissible Tmax.

Ladite étape dans laquelle on génère ou on augmente le débit de fluide caloporteur dans l'échangeur supplémentaire comprend ici une étape d'ouverture/fermeture de ladite vanne trois voies 18, en tout ou rien et/ou de façon partielle.

En particulier, au-dessus de la vitesse seuil du véhicule, on prévoit une situation initiale dans laquelle les volets sont clos de sorte que la section de passage du flux d'air est nulle ou minimum.

Au-dessus de la vitesse seuil du véhicule, on réalise d'abord la sous-étape (c) puis la sous-étape (b) si cela reste insuffisant par rapport à une consigne à atteindre. La sous-étape (a) présente par contre peu d'effets.

Successivement, on acquiert des informations sur le véhicule selon une première étape 100. On mesure le débit et la température de fluide de refroidissement ainsi que la vitesse et la température du flux d'air F1 selon une seconde étape 102. On acquiert des informations sur la boucle de circulation du fluide frigorigène selon une troisième étape 104 puis on effectue un test pour vérifier si la température du liquide de refroidissement est supérieure à une consigne, en prenant éventuellement en compte une incertitude de mesure, selon une quatrième étape 106.

Si le résultat de la quatrième étape 106 est négatif, la surveillance se poursuit en rebouclant à la première étape 100.

Si le résultat de la quatrième étape 106 est positif, une effectue alors un test pour vérifier si une vitesse de rotation du groupe moto-ventilateur est maximum, selon une cinquième étape 108.

Si le résultat de la cinquième étape 108 est négatif, on augmente alors la vitesse du groupe moto-ventilateur, ceci selon une sixième étape 110, et la surveillance se poursuit en rebouclant à la première étape 100.

Si le résultat de la cinquième étape 108 est positif, une effectue alors un test pour vérifier si une ouverture des volets est maximum, selon une septième étape 112.

Si le résultat de la septième étape 112 est négatif, on augmente alors l'ouverture des volets, ceci selon une huitième étape 114, et la surveillance se poursuit en rebouclant à la première étape 100.

Si le résultat de la septième étape 112 est positif, on effectue alors un test pour vérifier si le débit dans l'échangeur de chaleur supplémentaire 16 est maximum, selon une neuvième étape 116.

Si le résultat est négatif, on augmente alors le débit dans l'échangeur de chaleur supplémentaire 16, notamment grâce à la vanne trois voies 18 évoquée plus haut, ceci selon une ou des dixièmes étapes 118, et la surveillance se poursuit en rebouclant à la première étape 100.

Autrement dit, à l'arrêt et/ou à une vitesse du véhicule inférieur à la vitesse seuil, on réalise d'abord la sous-étape (a) puis, si cela reste insuffisant par rapport à la consigne à atteindre, on réalise la sous-étape (b), puis si cela reste insuffisant par rapport à la consigne à atteindre, on réalise la sous-étape (c).

Grâce à une telle stratégie, on optimise les possibilités de maintenir la température du fluide de refroidissement en dessous de la température maximale admissible Tmax en aval du convertisseur 10, y compris dans des conditions de fonctionnement du type fonctionnement à puissance maximale.

Si un tel résultat n'est pas atteint, que cela soit à haute ou basse vitesse, il est encore possible de délester le fonctionnement de la boucle de circulation du fluide frigorigène, par exemple en limitant une vitesse maximale du dispositif de compression 50.

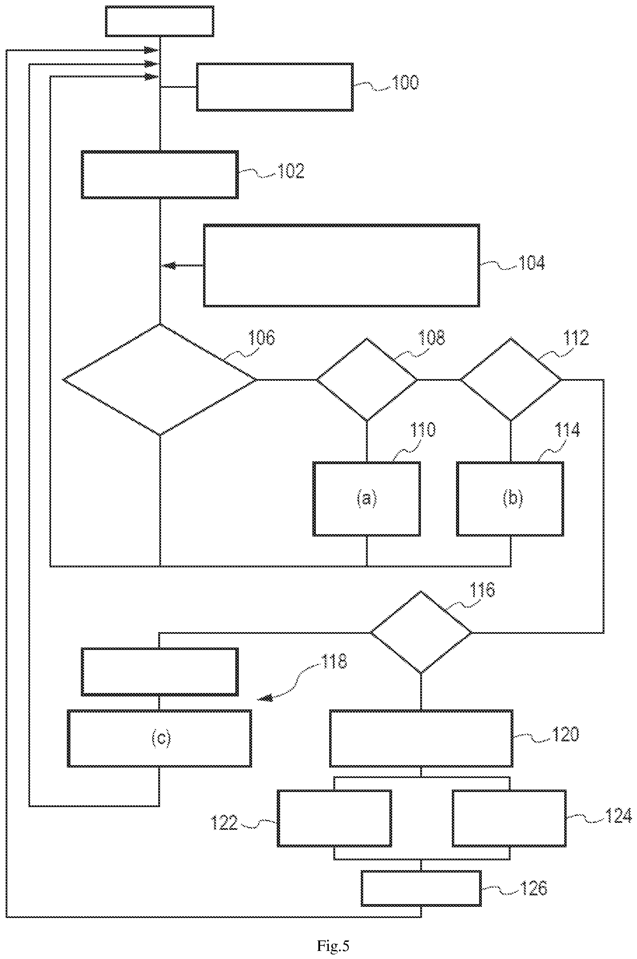

Ceci est illustré dans le mode de réalisation de la figure 5, dans le cas d'un roulage à basse vitesse donc, selon une onzième étape 120. On choisit alors si l'on souhaite donner la priorité à un bon fonctionnement de la climatisation du véhicule, selon une douzième étape 122 ou au refroidissement du dispositif de stockage électrique, selon une treizième étape 124. On adapte en conséquence la circulation du fluide frigorigène dans les échangeurs concernés, selon une quatorzième étape 126, suite à laquelle la surveillance se poursuit en rebouclant à la première étape 100.

Avantageusement, ladite vitesse seuil du véhicule, à savoir la vitesse en-dessous ou au-dessus de laquelle l'ordre des étapes (a), (b) et (c) varie, pourra être ajustée en fonction de la température ambiante.

## Revendications

1. Procédé de contrôle d'un circuit de régulation thermique d'un véhicule, ledit circuit comprenant des premier (2) et deuxième (4) échangeurs de chaleur situés en série selon un sens de circulation d'un flux d'air destiné à les traverser dans cet ordre, ledit circuit comprenant en outre un échangeur de chaleur supplémentaire (16) situé en amont du premier échangeur de chaleur (2) selon le sens de circulation du flux d'air, ledit circuit étant configuré pour autoriser une circulation d'un fluide frigorigène dans le premier échangeur (2) et une circulation d'un fluide caloporteur dans le deuxième échangeur (4) et dans l'échangeur supplémentaire (16), ledit procédé comprenant une étape dans laquelle on génère ou on augmente un débit du fluide caloporteur dans l'échangeur supplémentaire (16) en fonction de modes de fonctionnement du circuit, **caractérisé en ce que** le circuit comprend au moins une vanne (18) permettant, selon le sens de circulation dudit fluide caloporteur, de diriger sélectivement le fluide caloporteur en aval du deuxième échangeur (4) vers ledit échangeur supplémentaire (16) ou vers le reste du circuit.

2. Procédé selon la revendication 1 dans lequel ledit circuit est configuré de sorte à ce que le flux d'air qui traverse ledit échangeur de chaleur supplémentaire (16) soit un flux d'air ambiant.

3. Procédé selon l'une quelconque des revendications 1 ou 2 comprenant une étape de contrôle d'au moins un paramètre relatif au fluide caloporteur, ledit paramètre étant la température du fluide caloporteur, procédé dans lequel l'étape dans laquelle on génère ou on augmente le débit de fluide caloporteur dans l'échangeur supplémentaire s'effectue par comparaison de la valeur du paramètre par rapport à une valeur seuil.

4. Procédé selon l'une quelconque des revendications précédentes dans lequel ledit circuit est configuré pour que la circulation du fluide caloporteur permette un refroidissement d'un ou plusieurs éléments (8, 10) d'une chaîne de traction électrique du véhicule, en particulier un refroidissement d'un convertisseur électrique (10), destiné à convertir un courant électrique continu délivré par un dispositif de stockage électrique en courant alternatif pour alimenter un moteur électrique capable de mettre en mouvement ledit véhicule.

5. Procédé selon la revendication précédente comprenant une étape dans laquelle on autorise, sélectivement, une circulation du fluide caloporteur dans le deuxième échangeur (2) et une circulation du fluide caloporteur dans le deuxième échangeur (2) et dans l'échangeur de chaleur supplémentaire (16).

6. Procédé selon l'une quelconque des revendications précédentes dans lequel la circulation du fluide caloporteur dans le deuxième échangeur de chaleur (4) et l'échangeur de chaleur supplémentaire (16) s'effectue en série.

7. Procédé selon l'une quelconque des revendications précédentes dans lequel lesdits premier et deuxième échangeurs thermiques (2, 4) ainsi que ledit échangeur supplémentaire (16) sont destinés à être positionnés en face avant du véhicule.

8. Procédé selon la revendication précédente dans lequel, au-dessus d'une vitesse seuil du véhicule, on prévoit une situation initiale dans laquelle les volets sont clos de sorte que la section de passage du flux d'air est nulle ou minimum.

## Patentansprüche

1. Verfahren zur Steuerung eines Wärmeregulierungskreislaufs eines Fahrzeugs, wobei der Kreislauf einen ersten (2) und einen zweiten (4) Wärmetauscher beinhaltet, die gemäß einer Zirkulationsrichtung eines Luftstroms in Reihe angeordnet sind, welcher dazu bestimmt ist, sie in dieser Reihenfolge zu durchqueren, wobei der Kreislauf ferner einen Zusatzwärmetauscher (16) beinhaltet, der sich gemäß der Zirkulationsrichtung des Luftstroms stromaufwärts des ersten Wärmetauschers (2) befindet, wobei der Kreislauf dazu konfiguriert ist, eine Zirkulation eines Kältemittels in dem ersten Tauscher (2) und eine Zirkulation eines Wärmeträgermittels in dem zweiten Tauscher (4) und in dem Zusatztauscher (16) zuzulassen, wobei das Verfahren einen Schritt beinhaltet, während dessen ein Durchsatz des Wärmeträgermittels in dem Zusatztauscher (16) in Abhängigkeit von Betriebsmodi des Kreislaufs erzeugt oder erhöht wird, **dadurch gekennzeichnet, dass** der Kreislauf mindestens ein Ventil (18) beinhaltet, welches es gemäß der Zirkulationsrichtung des Wärmeträgermittels gestattet, das Wärmeträgermittel stromabwärts des zweiten Tauschers (4) selektiv zu dem Zusatzwärmetauscher (16) oder zu dem Rest des Kreislaufs zu leiten.

2. Verfahren nach Anspruch 1, wobei der Kreislauf so konfiguriert ist, dass der Luftstrom, der den Zusatzwärmetauscher (16) durchquert, ein Umgebungsluftstrom ist.

3. Verfahren nach einem der Ansprüche 1 oder 2, das einen Schritt des Steuerns mindestens eines wärmeträgermittelbezogenen Parameters beinhaltet, wobei der Parameter die Temperatur des Wärmeträgermittels ist, Verfahren, bei dem der Schritt, während dessen der Wärmeträgermitteldurchsatz in dem Zusatztauscher erzeugt oder erhöht wird, durch einen Vergleich des Wertes des Parameters mit einem Schwellenwert erfolgt.

4. Verfahren nach einem der vorhergehenden Ansprüche, wobei der Kreislauf dazu konfiguriert ist, dass die Zirkulation des Wärmeträgermittels eine Kühlung eines oder mehrerer Elemente (8, 10) eines Elektroantriebs des Fahrzeugs ermöglicht, insbesondere eine Kühlung eines elektrischen Umrichters (10), der dazu bestimmt ist, Gleichstrom, der von einer Elektrospeichervorrichtung bereitgestellt wird, in Wechselstrom umzuwandeln, um einen Elektromotor zu versorgen, der dazu fähig ist, das Fahrzeug in Bewegung zu setzen.

5. Verfahren nach dem vorhergehenden Anspruch, das einen Schritt beinhaltet, während dessen selektiv eine Zirkulation des Wärmeträgermittels in dem zweiten Tauscher (2) und eine Zirkulation des Wärmeträgermittels in dem zweiten Tauscher (2) und in dem Zusatzwärmetauscher (16) zugelassen wird.

6. Verfahren nach einem der vorhergehenden Ansprüche, wobei die Zirkulation des Wärmeträgermittels in dem zweiten Wärmetauscher (4) und dem Zusatzwärmetauscher (16) in Reihe erfolgt.

7. Verfahren nach einem der vorhergehenden Ansprüche, wobei der erste und der zweite Wärmetauscher (2, 4) sowie der Zusatztauscher (16) dazu bestimmt sind, an der Vorderseite des Fahrzeugs positioniert zu sein.

8. Verfahren nach dem vorhergehenden Anspruch, wobei oberhalb einer Schwellengeschwindigkeit des Fahrzeugs eine Anfangssituation vorgesehen ist, in der die Klappen geschlossen sind, sodass der Durchgangsquerschnitt des Luftstroms null oder minimal ist.

## Claims

1. Method for controlling a circuit for the thermal regulation of a vehicle, said circuit comprising a first (2) and a second (4) heat exchanger which are situated in series in a direction in which an air flow intended to pass through them in this order circulates, said circuit further comprising an additional heat exchanger (16) situated upstream of the first heat exchanger (2) according to the direction of circulation of the air flow, said circuit being configured to allow a refrigerant fluid to circulate through the first exchanger (2) and a heat-transfer fluid to circulate through the second exchanger (4) and through the additional exchanger (16), said method comprising a step in which a flow of the heat-transfer fluid in the additional exchanger (16) is generated or increased according to the mode of operation of the circuit, **characterized in that** the circuit comprises at least one valve (18) making it possible, depending on the direction of circulation of said heat-transfer fluid, to direct the heat-transfer fluid downstream of the second exchanger (4) selectively toward said additional exchanger (16) or toward the rest of the circuit.

2. Method according to Claim 1, wherein said circuit is configured in such a way that the air flow passing through said additional heat exchanger (16) is an ambient air flow.

3. Method according to either one of Claims 1 and 2 comprising a step of controlling at least one parameter relating to the heat-transfer fluid, said parameter being the temperature of the heat-transfer fluid, in which method the step wherein the flow of heat-transfer fluid in the additional exchanger is generated or increased is performed by comparing the value of the parameter against a threshold value.

4. Method according to any one of the preceding claims, wherein said circuit is configured so that the circulation of the heat-transfer fluid allows a cooling of one or more components (8, 10) of an electric powertrain of the vehicle, particularly a cooling of an electric converter (10) intended to convert a DC electric current delivered by an electrical storage device into an AC current for powering an electric motor capable of causing said vehicle to move.

5. Method according to the preceding claim comprising a step of selectively allowing a circulation of the heat-transfer fluid through the second exchanger (2) and a circulation of the heat-transfer fluid through the second exchanger (2) and through the additional heat exchanger (16).

6. Method according to any one of the preceding claims, wherein the circulation of the heat-transfer fluid through the second heat exchanger (4) and through the additional heat exchanger (16) is performed in series.

7. Method according to any one of the preceding claims, wherein said first and second heat exchangers (2, 4) as well as said additional exchanger (16) are intended to be positioned on the front face of the vehicle.

8. Method according to the preceding claim, wherein, when the vehicle speed is above a threshold speed, there is an envisioned initial situation in which the flaps are closed so that the cross section for the passage of the air flow is nil or minimal.
